# EUROPEAN PATENT SPECIFICATION

(11) **EP 0 308 869 B1**
(45) Date of publication and mention of the grant of the patent: **31.05.1995**
(21) Application number: 88115399.3
(22) Date of filing: 20.09.1988
(51) Int. Cl.: H01L 39/12, H01L 39/24, C30B 25/02, C30B 29/16

(54) **Process of producing single crystalline LnA2Cu3O7-x thin films having three-layered perovskite structure**
Verfahren zur Herstellung monokristalliner dünner Schichten aus LnA2Cu307-x mit einer Perovskit-Struktur mit 3 Ebenen
Procédé de fabrication de couche minces monocristallines de LnA2Cu307-x ayant une structure de perovskite à 3 niveaux

(30) Priority: 21.09.1987 JP 236792/87; 21.09.1987 JP 236793/87; 11.12.1987 JP 314670/87; 15.12.1987 JP 318074/87; 15.02.1988 JP 33630/88; 10.03.1988 JP 57207/88; 28.03.1988 JP 75486/88
(43) Date of publication of application: 29.03.1989
(73) Proprietor: Kanegafuchi Chemical Industry Co., Ltd., Kita-ku Osaka-shi Osaka-fu (JP); MATSUSHITA ELECTRIC INDUSTRIAL CO., LTD., Kadoma-shi, Osaka-fu, 571 (JP); NEC CORPORATION, Tokyo (JP); JAPAN ENERGY CORPORATION, Minato-ku, Tokyo (JP); NIPPON STEEL CORPORATION, Tokyo (JP); TDK Corporation, Chuo-ku, Tokyo-to 103 (JP); Tosoh Corporation, Shinnanyo-shi Yamaguchi-ken (JP); Toyo Boseki Kabushiki Kaisha, Osaka-shi Osaka 530 (JP); SEISAN KAIHATSU KAGAKU KENKYUSHO, Sakyo-ku Kyoto-shi Kyoto-fu 606 (JP); UBE INDUSTRIES, LTD., Ube-shi, Yamaguchi-ken 755 (JP)
(72) Inventor: Takada, Toshio, Sakyo-ku, Kyoto-shi Kyoto-fu (JP); Terashima, Takahito, Sakyo-ku, Kyoto-shi Kyoto-fu (JP); Bando, Yoshichika, Ohtsu-shi Shika-ken (JP)
(74) Representative: VOSSIUS & PARTNER

(56) References cited:
- APPLIED PHYSICS LETTERS, vol. 51, no. 11, 14 September 1987, New York, US, pp. 852-854; B. OH et al.: "Critical current densities and transport in superconducting YBa2Cu307-d films made by electron beam coevaporation"
- JAPANESE JOURNAL OF APPLIED PHYSICS, vol. 26, no. 5, May 1987, Tokyo, JP, pp. 876-878; M. ONODA et al.: "Crystal structures of YBa2Cu30x and LnBa2Cu30x(Ln=Ho and Dy)"
- JAPANESE JOURNAL OF APPLIED PHYSICS, vol. 26, no. 7, July 1987, Tokyo, pp. 1248-1250; Y. ENOMOTO et al.: "Largely anisotropic superconducting critical current in epitaxially grown Ba2YCu3O7-y thin film"
- JAPANESE JOURNAL OF APPLIED PHYSICS, vol. 27, no. 1, January 1988, Tokyo, pp. 91-93; T. TERASHIMA et al.: "Single-crystal YBa2Cu3O7-x thin films by activated reactive evaporation"
- APPLIED PHYSICS LETTERS, vol. 51, no. 26, 28 December 1987, New York, US, pp. 2263-2265; H. ADACHI et al.: "Low-temperature process for the preparation of high Tc superconducting thin films"
- JAPANESE JOURNAL OF APPLIED PHYSICS, vol. 26, no. 11, November 1987, Tokyo, JP, pp. 1921-1924; M. SUZUKI et al.: "Anisotropic properties of superconducting (La1-xSrx)2CuO4 single-crystal thin films"

## Description

The present invention relates to a process of producing a thin film of a single crystalline oxide of the formula:

LnA₂Cu₃O₇₋ₓ (I)

wherein Ln is at least one of the rare earth elements Y, Nd, Sm, Eu, Gd, Dy, Ho, Er, Tm and Yb and A is at least one of the alkaline earth metals Ba, Sr and Ca which has a three-layered perovskite structure.

A thin film of LnA₂Cu₃O₇₋ₓ having a three-layered perovskite structure exhibiting superconductivity around 90 K will find various new applications such as wiring of LSI, SQUID and Josephson tunnel type elements.

For such applications, the LnA₂Cu₃O₇₋ₓ thin film should have a critical temperature Tc at 85 K or higher, a critical current density Jc of 10⁵ A/cm² or higher when the film is not thicker than 500 nm (5,000 Å) and should be formed at a comparatively low temperature.

Since a wiring material of LSI is required to have a large current density, the single crystalline thin film should have a specific plane such as a (001), (110) or (103) plane parallel with a film plane so that electric current can flow in said specific plane.

In the Josephson tunnel type element using the superconducting LnA₂Cu₃O₇₋ₓ, an insulating ultrathin layer between the superconductors for tunnel junction is required to have a thickness of not larger than 3 nm (30 Å). To form such junction, it is essential to produce a superconductive film having good surface smoothness and an ultrathin insulating layer on it. The thickness of the insulating ultrathin layer for forming a junction is limited by the coherence length of the superconductor. The coherence length in thedirection perpendicular to the (001) plane is about 0.4 to 0.7 nm (4 to 7 Å), and that in the direction parallel to said plane is about 1.5 to 3.0 nm (15 to 30 Å).

Therefore, the thickness of the insulating ultrathin layer to be used for junction varies with the kind of the superconductor and its crystal direction to be connected. When the direction perpendicular to the (001) plane of the superconductor coincides with the direction perpendicular to the surface of the insulating layer, the thickness of the latter should be 1.0 nm (10 Å) or less. On the contrary, when the direction parallel with the (001) plane of the superconductor coincides with the direction perpendicular to the surface of the insulating layer, the thickness of the latter can be as thick as several nm (ten Å), which makes the formation of tunnel junction easy. Accordingly, a (110) oriented single crystal film may be more available for the tunnel type junction than a (001) oriented film.

In the practical applications, it is required to provide a single crystallinefilm having the (110) plane in the direction parallel with the film plane. In addition, since a single crystalline film with an other orientation can achieve a large current density, it is suitable for forming a wire to be used in a superconductive magnet.

In most cases, the single crystalline film of LnA₂Cu₃O₇₋ₓ has been prepared by a sputtering method. The sputtering method comprises irradiating a plasma of oxygen (O₂) and/or argon gas against a target consisting of a Ln-A-Cu base oxide in a vacuum vessel and depositing sputtered metals and the like on a substrate such as a SrTiO single crystal piece placed in said vessel to form a LnA₂Cu₃O₇₋ₓ thin film. To covert the deposited LnA₂Cu₃O₇₋ₓ thin film to a film exhibiting high quality superconductivity with Tc of 77 K or higher, it is necessary to thermally treat the film at a temperature of 800°C or higher.

By the scientists in the Watson Research Laboratory of IBM or the Stanford University, a superconductive oxide thin film is produced by electron beam deposition. But, the as-deposited film is amorphous and does not have superconductive characteristics as such. Therefore, the deposited film is post-heated at a high temperature of 800 to 1,000°C to crystallize the amorphous film to a perovskite crystal having a three-layered structure, whereby the produced film exhibits superconducting transition at 77 K or higher (see for example, Applied Physics Letters, Vol 51, No 11, 14 Sept. 1987, pp. 852-854).

By the conventional sputtering method or the conventional electron beam deposition, no film which is substantially a single crystal having the (001), (110) or (103) plane parallel with the film surface has been provided, and either method has its own drawbacks.

For example, in the sputtering method, it is difficult to prepare the target with a composition optimum for the formation of the superconducting film. Since a desired material is deposited solely by attacking the target with ions, not only characteristics of the film are delicately changed according to conditions of the plasma atmosphere and to quality of the target, but also the substrate or the deposited film is easily modified by ions. Therefore, this method has poor reproducibility.

Another problem resides in that the epitaxially grown LnA₂Cu₃O₇₋ₓ oxide film should be thermally treated at a temperature of 800°C or higher to increase the critical temperature to 77 K or higher, preferably 85 K or higher. By the thermal treatment, the surface of the thin film is roughened. Further, due to thermal treatment at high temperature, the substrate material and LnA₂Cu₃O₇₋ₓ react with each other so that the thin layer having a thickness of 500 Å or less cannot be made superconductive.

A superconductive thin film which is produced by sputtering and subsequent thermal treatment at the lowest temperature is a 200 to 300 nm (2,000 to 3,000 Å) thick (001) oriented crystal film of YBa₂Cu₃O₇₋ₓ which is formed on a sapphire substrate heated at a temperature of 550 to 650°C. It is reported that this film had zero electric resistance at 80 K after thermally treated at a temperature of 550 to 650°C.

However, the critical temperature of 80 K is still unsatisfactory, and the produced film seems to be heterogeneous from the results of X-ray analysis and change of electrical resistance against temperature.

In the conventional electron beam deposition, the deposited film should be thermally treated at a high temperature. Therefore, the kind of the substrate to be used is limited. When the substrate is inadequate, it reacts with the deposited material so that a part or whole of the deposited material is changed to a material which is different from the superconductor.

Further, the surface of the deposited film is less smooth. Because of the reaction between the substrate and the deposited material, it is difficult to obtain the superconducting film with a thickness of 500 nm (5,000 Å) or less.

The object of the present invention is to provide a process of producing a thin film of a LnA₂Cu₃O₇₋ₓ single crystal having the perovskite structure directly on a deposition substrate.

According to the object of the present invention, there is provided a process of producing a thin film consisting of a single crystalline oxide superconductor of the formula:

LnA₂Cu₃O₇₋ₓ (I)

wherein Ln is at least one of the rare earth elements Y, Nd, Sm, Eu, Gd, Dy, Ho, Er, Tm and Yb and A is at least one of the alkaline earth metals Ba, Sr and Ca which has a three-layered perovskite structure, which comprises simultaneously evaporating Ln, A and Cu in an atomic ratio of about 1:2:3 from discrete evaporation sources of Ln, A and Cu to deposit them on a single crystal substrate in a vacuum deposition vessel while supplying oxygen gas towards the substrate to form an oxygen-rich atmosphere having a pressure of 1.33 to 13.3 Pa (10⁻² to 10⁻¹ Torr) at the substrate.

There is also provided a process of producing the above described thin film of the LnA₂Cu₃O₇₋ₓ single crystal, which comprises generating plasma and simultaneously evaporating Ln, A and Cu in an atomic ratio of about 1:2:3 from discrete evaporation sources of Ln, A and Cu to deposit them on a single crystal substrate in a vacuum deposition vessel while supplying oxygen gas towards the substrate to form an oxygen-rich atmosphere having a pressure of 1.33 to 13.3 Pa (10⁻² to 10⁻¹ Torr) at the substrate.

In a preferred embodiment the single crystal used as the substrate has its (001) plane forming the substrate surface, and the (001) plane of the formed single crystal is parallel with the film surface; in another one in both cases (110) plane is used; in a third one the single crystal used as the substrate has its (110) plane forming the substrate surface, and the (103) plane of the formed single crystal is parallel with the film surface.

It is also preferred to heat the substrate to a temperature of not lower than 500°C while depositing the film.

The oxygen content is not stoichiometric in the superconductive oxide of formula (I); oxygen may be present in a richer or poorer amount than the calculated stoichiometric amount.
Figs. 1 and 2 are X-ray diffraction patterns of the thin films of YBa₂Cu₃O₇₋ₓ single crystal produced in Examples 1 and 2, respectively,
Fig. 3 is a graph showing the relationship between the resistivity and absolute temperature for the thin film of YBa₂Cu₃O₇₋ₓ single crystal produced in Example 3,
Figs. 4 and 5 are graphs showing the relationship between the resistivity and absolute temperature and the relationship between the complex susceptibility x and x" (χ =χ′ - iχ˝) which is measured under the AC-magnetic field applied perpendicular to the film surface and absolute temperature, respectively for the thin film of YBa₂Cu₃O₇₋ₓ single crystal having a thickness of 200 nm (2,000 Å) formed on the non-etched (100) surface of SrTiO₃ single crystal in Example 4,
Figs. 6, 7, 8 and 9 are X-ray diffraction patterns of the thin films of YBa₂Cu₃O₇₋ₓ single crystal formed in Example 7, the thin film of DyBa₂Cu₃O₇₋ₓ single crystal formed in Example 8, the thin film of ErBa₂Cu₃O₇₋ₓ single crystal formed in Example 8, and the thin film of YBa₂Cu₃O₇₋ₓ formed in Example 9, respectively,
Figs. 10 and 11 are graphs showing the relationship between the resistivity and absolute temperature and the relationship between the complex susceptibility and the absolute temperature, respectively for the thin film of YBa₂Cu₃O₇₋ₓ single crystal formed in Example 9,
Figs. 12A, 12B, 13A, 13B, 14A, 14B, 15A and 15B are the reflecting high energy electron diffraction (hereinafter referred to as "RHEED") photographs showing the crystal structure of the thin film of YBa₂Cu₃O₇₋ₓ single crystal formed in Example 10,
Fig. 16 is a graph showing the relationship between the resistivity and absolute temperature of the thin film formed in Example 10,
Figs. 17A, 17B, 18A, 18B, 19A and 19B are the RHEED patterns revealing the crystal orientation of the thin film of ErBa₂Cu₃O₇₋ₓ single crystal formed in Example 11,
Figs. 20A and 20B are the RHEED patterns revealing the crystal orientation of the thin film of YBa₂Cu₃O₇₋ₓ single crystal formed in Example 12, and
Fig. 21 is a graph showing the relationship between the resistivity and absolute temperature of the thin film formed in Example 12.

The microstructure, namely a polycrystalline or a single crystalline structure in the formed thin film of LnA₂Cu₃O₇₋ₓ depends on the kind of the substrate.

That is, to produce the thin film of the LnA₂Cu₃O₇₋ₓ single crystal with the orientation (001) or (110), a single crystal of SrTiO₃, MgO, CoO, NiO and the like having the (001) plane or the (110) plane in its surface is used as a substrate, respectively.

The processes of producing the thin film of the LnA₂Cu₃O₇₋ₓ single crystal can be applied to the production of a polycrystalline LnA₂Cu₃O₇₋ₓ. In this case, the kind of the substrate is not limited.

As described above, to produce the single crystalline LnA₂Cu₃O₇₋ₓ having the specific crystal plane parallel with the substrate surface, the substrate should have said specific crystal plane on its surface.

The above requirements for the substrate are necessary conditions to make the specific crystal plane parallel with the substrate surface, but not sufficient conditions.

Suitable conditions for producing the thin film of the LnA₂Cu₃O₇₋ₓ single crystal of the orientation (001) and those for producing the thin film of the LnA₂Cu₃O₇₋ₓ single crystal of the orientation (110) are different as follows:

In the former case, the raw material metals are evaporated and deposited on the substrate heated at 500°C or higher, while in the latter case, the raw material metals are evaporated and deposited on the substrate heated at a temperature not lower than 500°C and lower than 550°C to form the single crystalline LnA₂Cu₃O₇₋ₓ having the orientation (110) and, after raising the substrate temperature to 550°C or higher, the metals are further deposited on the already formed single crystal.

Namely, the LnA₂Cu₃O₇₋ₓ single crystal having the orientation (001) can be produced under a relatively wide temperature range of 500°C or higher, preferably 520°C or higher but not so high as to adversely affect the substrate and the growing film. Thereby, a thin film having very good crystal structure is formed. On the contrary, when the thin film of the LnA₂Cu₃O₇₋ₓ single crystal having the orientation (110) is produced, as described above, the substrate is heated at a temperature not lower than 500°C and lower than 550°C, preferably around 530°C in the first evaporation step so as to render the new substrate of LnA₂Cu₃O₇₋ₓ thin film suitable for the formation of the desired material having the orientation (110) and, in the second step, the temperature at the new substrate is raised to 550°C or higher, preferably 600°C or higher. Under other conditions, no thin film having good superconductive characteristics is formed.

In other words, although the thin films formed in the first and second steps consist of the desired material, the thin film produced in the first step is used as a base film in the second step and only the thin film formed in the second step has good superconductive characteristics. As understood from below described working examples, the first and second steps are not necessarily carried out continuously.

In the present invention, the kind of the crystal plane is selected and the substrate temperatures are determined according to the orientation of the LnA₂Cu₃O₇₋ₓ single crystal to be formed on the substrate. The thin film of the LnA₂Cu₃O₇₋ₓ single crystal having the orientation (103) can be formed on the substrate at a higher temperature although the same crystal plane as in the case of the orientation (110) is used as the substrate. That is, to form the thin film of the LnA₂Cu₃O₇₋ₓ single crystal having the orientation (103), the thin film is deposited on the substrate heated at 550°C or higher, preferably 600°C or higher.

The process of the present invention will be explained further in detail.

The vacuum deposition vessel is firstly evacuated to high vacuum of, for example, about 1.33 x 10⁻⁴ Pa (10⁻⁶ Torr) and then a small amount of the oxygen gas is continuously supplied towards the substrate from a distance close to the substrate to increase the pressure of oxygen at the substrate to 1.33 to 13.3 Pa (10⁻² to 10⁻¹ Torr) while an interior gas in the vessel is continuously exhausted from a suitable part of the vessel to keep the background at 1.33 x 10⁻³ to 0.13 Pa (10⁻⁵ to 10⁻³ Torr) in the vessel except near the substrate. The reason why the upper limit of the background pressure is selected to be 0.13 Pa (10⁻³ Torr) is that Ln, A and Cu in the evaporation sources are constantly evaporated without deterioration of evaporation rates. The lower limit of 1.33 x 10⁻³ Pa (10⁻⁵ Torr). is the minimum gas pressure for generating the plasma.
If the plasma is not utilized, this lower limit is not technically important.

The reason why the oxygen gas pressure is increased only near the substrate in this embodiment is that Cu is not oxidized to Cu²⁺ if the oxygen gas pressure is lower than 0.13 Pa (10⁻³ Torr).

The plasma can be generated by placing a high frequency coil between the evaporation sources and the substrate and oscillating it between the coil and the vessel wall at high frequency. While the plasma generation is preferred since reaction activities of the evaporated metals are increased, it may have some drawbacks such that the plasma attacks the desired material which is being formed if the plasma energy is too high. Therefore,the electric power for generating the plasma is preferably in a range from 50 to 500 W, preferably around 100 W.

Ln and A are evaporated by the electron beam and Cu is evaporated by electric resistance heating.

During evaporation of the metals by the above described evaporation means, the atomic ratio of Ln, A and Cu is adjusted to about 1:2:3 by adjusting the electric power according to results of preliminary experiments. Namely, in the preliminary experiments, how much metal Ln, A or Cu is evaporated and how much oxide Ln₂O₃, AO or CuO is formed by the specific electric power applied to each evaporation source per unit time are measured by a film thickness measuring device installed in the vacuum evaporation vessel near the substrate for each metal. Thereby, a relationship between the evaporation rate of each metal and the applied electric power is established and then the electric power to be applied to each evaporation source during formation of the thin film of the LnA₂Cu₃O₇₋ₓ single crystal is determined.

As is clear from the comparison with the conventional sputtering method, the process of the present invention can produce reproducibly the desired material since it can be carried out while preventing contamination with impurities under easily controlled operating conditions.

The present invention has been completed based on the studies by the present inventors on the preparation and structures of thin films of oxide single crystals and their artificial superlattice thin films. According to the present invention, the oxide thin film is formed by the reactive evaporation. This is because this method has been found to be most suitable for producing the desired material which is required to have a good crystalline quality.

The reactive evaporation for preparing the oxide is a process comprising introducing the oxygen gas in the vacuum vessel, supplying metal atoms by evaporation on the substrate and forming the oxide while reacting the metal atoms with oxygen on the substrate.

The reasons why the reactive evaporation is suitable for the formation of oxide thin film are that (a) the amount of oxygen in the oxide can be controlled and (b) a single crystal with good quality in crystallinity is formed.

As to the reason (a), factors which determine the amount of oxygen in the oxide include the oxygen pressure, the substrate temperature, deposition rates of the metals and the kind of the substrate material. Since each of these factors can be changed independently from others, the amount of oxygen in the oxide can be freely adjusted. As to the reason (b), it has been found that when the single crystal is used as the substrate, a single crystal with excellent quality can be formed on the substrate. For example, when NiO is deposited on a sapphire C plane kept at 200°C under oxygen pressure of 5.32 x 10⁻² Pa (4 x 10⁻⁴ Torr) at a deposition rate of 0.1 nm/sec (1 Å/sec.), NiO single crystal is synthesized with the (111) plane being parallel with the substrate surface. A half value width in a rocking curve according to X-ray scattering on this single crystal is 0.5°. When the oxygen plasma is generated by RF excitation during the above synthesis, the half value width decreases to 0.06°. This means increase of crystallinity.

In the artificial super lattice thin film in which layers of NiO and CoO are alternately accumulated, as the thickness of each layer is decreased, the rocking curve becomes sharp and is substantially the same as that of the sapphire.

As understood from the above explanation, the reactive evaporation has suitable characteristics for synthesizing a single crystal with good quality. The reason for this is assumed as follows:

Growth of a crystal with forming a smooth surface is so called a single crystal growth. For such growth, following conditions should be met:
(1) The crystal is grown under conditions which are close to thermodynamical equilibrium.
(2) L/RT is larger than 2 where L is a latent heat for crystallization.

The condition (1) is achieved by (i) a small rate of crystal growth and (ii) preferential adsorption of the atoms onto high energy sites in the surface such as vacancies, kinks and steps. The condition (2) is easily satisfied by low temperature during crystal growth.

In the reactive evaporation, the condition (1) is achieved by following conditions:

Since oxygen molecules are adsorbed only by metal atoms, they are always adsorbed by and desorbed from the crystal surface to establish equilibrium. On the contrary, generally once adsorbed metal atoms are not desorbed. However, the metal atoms having higher energy acquired in the evaporation source can sufficiently move over the crystal surface so that they are adsorbed by the high energy sites on the crystal surface. If the energy distribution of the metal atoms which arrive at the surface is narrow and the number of such metal atoms is decreased to such extent that each atom does not come into collision with other metal atoms on the surface, the condition (1) is achieved. To prevent the change of energy of the impinging metal atoms, the molecular beam is desirable if possible. Therefore, the pressure (oxygen pressure) is decreased to an order of 1.33 x 10⁻² Pa (10⁻⁴ Torr) so as to increase their mean free path. In case of a metal having a low evaporation temperature such as Zn, it should be excited by RF to improve the quality of the ZnO single crystal.

As described above, the reactive evaporation has been found to be one of the best methods for controlling the crystal growth conditions of the oxide, and the present invention has been completed.

The present invention will be illustrated by the following Examples.

### Example 1

A vacuum vessel having a diameter of 750 mm and a height of 1,000 mm was evacuated to 1.33 x 10⁻⁴ Pa (10⁻⁶ Torr) by an oil diffusion pump.

As a substrate, a piece of sapphire (single crystal α-Al₂O₃) was used with the (0112) plane forming the substrate surface (10 mm x 10 mm). After placing the sapphire substrate in the vacuum vessel, it was heated to 650°C and kept at this temperature with a tungsten heater.

From two nozzles for supplying the oxygen gas provided near both ends of the substrate, the oxygen gas was directly blown onto the substrate, whereby the gas pressure was increased to 1.33 to 13.3 Pa (10⁻² to 10⁻¹ Torr) only near the substrate, while the pressure near the evaporation sources which were placed apart from the substrate was increased to about 1.33 x 10⁻² Pa (10⁻⁴ Torr).

Metals Y, Ba and Cu were evaporated from independent evaporation sources at such evaporation rates that the atomic ratio of Y:Ba:Cu was 1:2:3 on the substrate. For example, Y, Ba and Cu were evaporated at rates of 0.1 nm/sec (1 Å/sec.), 0.23 nm/sec (2.3 Å/sec.) and 0.17 nm/sec (1.7 Å/sec.), respectively.

Between the substrate and the evaporation sources, a high-frequency (13.56 MHz) coil was placed, and high frequency was applied at 100 W so as to generate oxygen plasma, which activated the evaporated metals and accelerated the reactions on the substrate.

Under the above conditions, the metal oxides were deposited on the substrate to form a thin film having a thickness of 100 nm (1,000 Å).

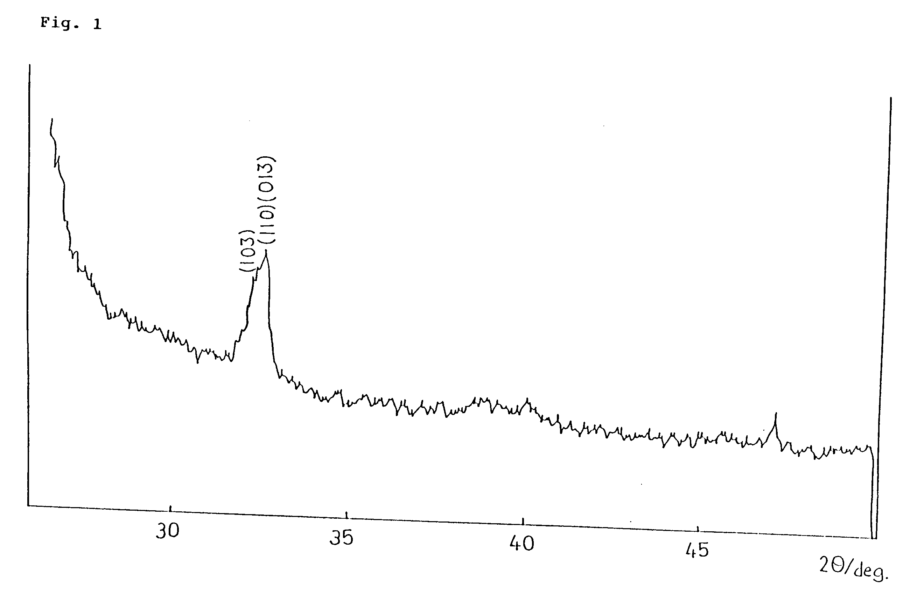

An X-ray diffraction pattern of the formed thin film is shown in Fig. 1.

Peaks for (013), (103) and (110) which are specific to the YBa₂Cu₃O₇₋ₓ structure are clearly observed and the formation of a crystalline film is confirmed.

In the above procedures, Y and Ba were evaporated by an electron beam, and Cu was evaporated by resistance heating. The evaporation conditions were as follows:
Y:
A metal ingot (purity: 99.9 %) (50 g) was used and placed in a crucible cooled with water. The metal was evaporated by the application of an electron beam at an acceleration voltage of 5 KV and a filament current of 400 mA.
Ba:
A metal ingot (purity: 99.9 %) (50 g) was used and evaporated by the application of the electron beam at an acceleration voltage of 5 KV and a filament current of 100 mA.
Cu:
In an alumina crucible around which a tungsten filament was wound, metal Cu particles (particle size of 2 to 3 mm, purity of 99.9999 %) (10 g) were charged and heated by the application of electric current through the filament at 10 V, 30 A.

### Example 2

A vacuum vessel having a diameter of 750 mm and a height of 1,000 mm was evacuated to 1.33 x 10⁻⁴ Pa (10⁻⁶ Torr). by an oil diffusion pump.

The (001) plane of a SrTiO₃ single crystal was used as a substrate (10 mm x 10 mm). After placing the substrate in the vacuum vessel, it was heated to 650°C and kept at this temperature with a tungsten heater.

From two nozzles for supplying the oxygen gas provided near both ends of the substrate, the oxygen gas was directly blown onto the substrate, whereby the gas pressure was increased to 1.33 to 13.3 Pa (10⁻² to 10⁻¹ Torr) only near the substrate, while the pressure near the evaporation sources which were placed apart from the substrate was increased to about 1.33 x 10⁻² Pa (10⁻⁴ Torr).

Metals Y, Ba and Cu were evaporated from separate evaporation sources at such evaporation rates that the atomic ratio of Y:Ba:Cu was 1:2:3 on the substrate. For example, Y, Ba and Cu were evaporated at rates of 0.1 nm/sec (1 Å/sec.), 0.23 nm/sec (2.3 Å/sec.) and 0.17 nm/sec (1.7 Å/sec.), respectively.

Between the substrate and the evaporation sources, a high-frequency coil was placed, and high frequency was applied at 100 W so as to generate oxygen plasma, which activated the evaporated metals and accelerated the reactions on the substrate.

Under the above conditions, the metal oxides were deposited on the substrate to form a 100 nm (1,000 Å) thick film.

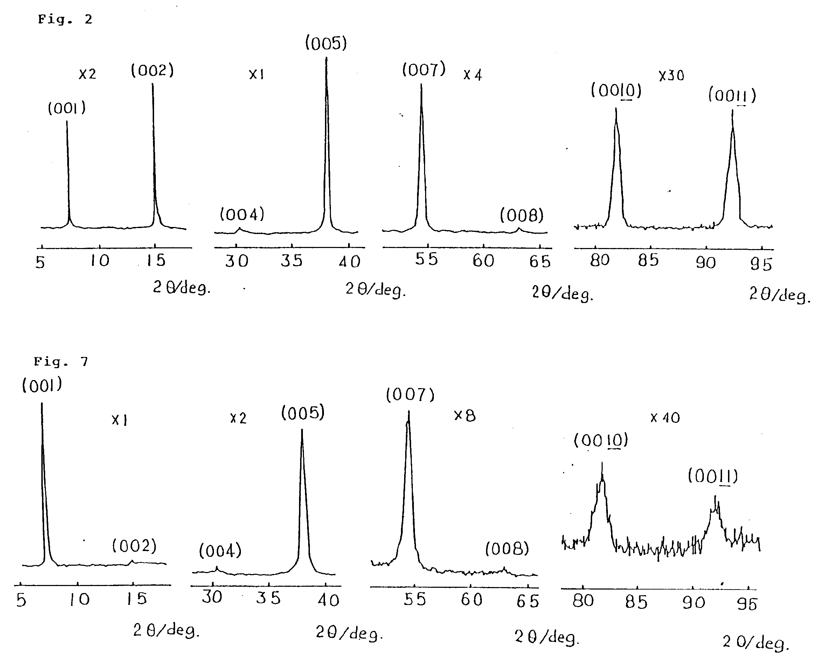

An X-ray diffraction pattern of the formed thin film is shown in Fig. 2, in which "x2", "x1", "x4" and "x30" indicate how many times the intensities were magnified.

The formed thin film was heated at 650°C for 30 minutes in the oxygen atmosphere and its critical current density at 77 K (liquid nitrogen temperature) was measured to find that it had the critical current density of 4 x 10⁶ A/cm². This value was large in comparison with 1.8 x 10⁶ A/cm² of the critical current density of the YBa₂Cu₃O₇₋ₓ type superconducting film made by sputtering.

### Example 3

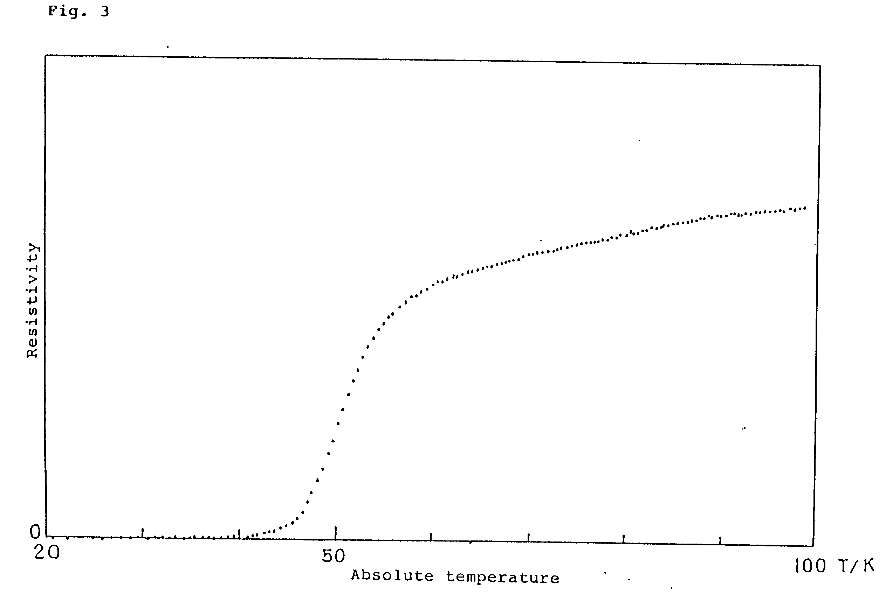

In the same manner as in Example 2, a thin film of a YBa₂Cu₃O₇₋ₓ single crystal having the three-layered perovskite structure and a thickness of 300 nm (3,000 Å) was formed. After ten days from the formation of this thin film, the relationship between its resistivity and absolute temperature was measured. The results are shown in Fig. 3.

As is apparent from Fig. 3, the formed thin film exhibited superconductivity at a temperature slightly lower than 50 K. Such characteristics appear when an oxidation degree (X) is low. Further, it is apparent from Fig. 3 that the thin film had the orthorohmbic symmetry. After the thin film was heated to 500°C for 30 minutes in the oxygen atmosphere, its electric resistance became 0 (zero) at 90 K.

The above results indicate that the thin film of the single crystal of the present invention is different from the conventional ones and the produced thin film as such has superconductivity without post-heat-treatment at a high temperature of 900°C.

### Example 4

Surface morphological properties of the thin film of YBa₂Cu₃O₇₋ₓ single crystal deposited in the same manner as in Example 2 were checked as follows:

As substrates, two pieces of SrTiO₃ single crystal were used, one of which had been surface polished and the other of which had been surface polished and further chemically etched with a mixture of hydrofluoric acid and nitric acid. The non-etched substrate, a thin film of 30 nm (300 Å) in thickness formed on it and a thin film of 100 nm (1,000 Å) in thickness formed on it were examined by a scanning electron microscope (SEM). As the result, it was found that the polished surface of the SrTiO₃ single crystal was comparatively smooth, so that the thin film formed on it was continuous and had very smooth surface even when the thickness is only 30 nm (300 Å). Further, it was found that the thin film was smooth when the film thickness reached 100 nm (1,000 Å).

The etched substrate and the 100 nm (1,000 Å) thick film formed on it were examined by SEM, and it was found that the surface of the etched substrate had hillocks of several micrometers. Further, it was found that the SEM photograph of the thin film of 100 nm (1,000 Å) in thickness formed on the etched substrate was substantially the same as above and the thin film grew on the substrate with tracing the substrate surface exactly. This means that the deposition according to the present invention overgrew a uniformly thick film on the substrate surface and therefore made the smooth surface of the film on the same of substrate.

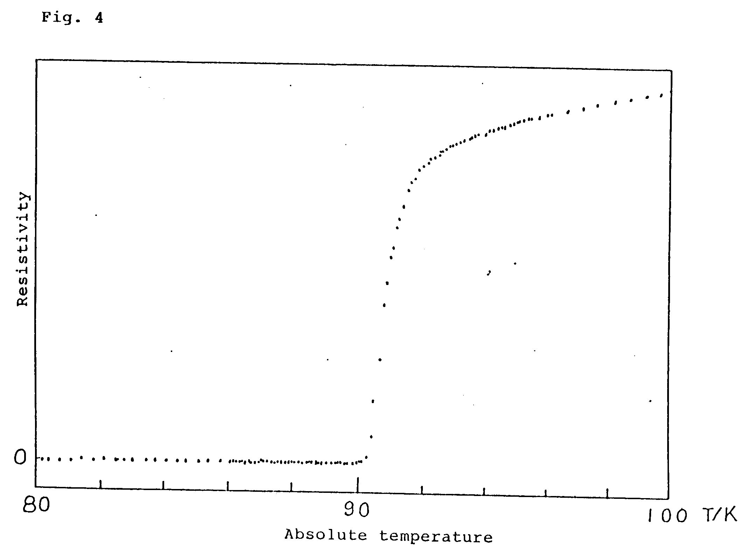

Fig. 4 shows change of resistivity against temperature of a thin film having a thickness of 200 nm (2,000 Å) which was formed on the polished substrate and heat treated in the oxygen atmosphere in the same manner as in below described Example 5. A transition temperature as defined by zero resistivity was 90.2 K and the temperature range in which resistivity changed was as small as 1.7 K, which suggested that a superconductive thin film with excellent quality was formed.

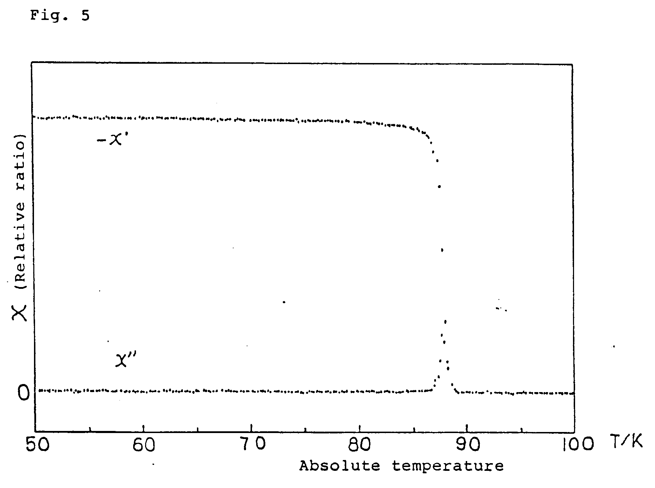

Fig. 5 shows change of complex susceptibility χ′ and χ˝ against temperature of the same sample. Around the temperature at which the electrical resistance dropped to zero, a real part of the complex susceptibility (-χ′) sharply increased and simultaneously its imaginary part (χ˝) began to appear. These results indicate that the Meisner effect was observed when the electrical resistance became zero.

From the above facts, it can be concluded that the substrate on which the thin film of the LnA₂Cu₃O₇₋ₓ single crystal is formed preferably has a smoothly polished surface and, on such substrate, the superconductive thin film having a smooth surface and excellent quality can be formed, so that it will be particularly useful in the production of electrical devices such as a SQUID device and a Josephson device.

### Example 5

Since the thin film just formed on the substrate does not necessarily exhibit good superconductivity, it is sometimes post-treated in an oxygen-containing atmosphere.

In this Example, effects of the post-treatment was confirmed on the YBa₂Cu₃O₇₋ₓ single crystal formed in the same manner as in Example 2.

After deposition and cooling the evaporation sources (30 minutes), oxygen gas was introduced into the vacuum vessel to pressurize the vessel to 1 atm. During this period, the substrate temperature was decreased to 500°C. Then, the thin film of YBa₂Cu₃O₇₋ₓ single crystal was kept at 500°C under an oxygen pressure of 101 325 Pa (1 atm). for 1 hour to adjust the oxygen content in the thin film. The lattice constant c₀ of the non-oxidation-treated thin film in the [001] direction calculated from the X-ray diffraction pattern was 1.1749 nm (11.749 Å), while that of the oxidation-treated thin film was 1.1686 nm (11.686 Å). The lattice constant after post-treatment substantially corresponds to that of a bulk crystal having a critical temperature of 90 K class. The superconductive characteristics of the oxidation-treated thin film has been already shown in Example 4.

### Example 6

In the same manner as in Example 2 but using SrTiO₃ with its (110) plane forming the surface and heating the substrate to 520°C, a thin film of YBa₂Cu₃O₇₋ₓ single crystal having a thickness of 200 nm (2,000 Å) was formed.

In this Example, RHEED photographs of the substrate itself and the formed thin film of YBa₂Cu₃O₇₋ₓ single crystal were taken. The photographs confirmed that the (110) plane of the YBa₂Cu₃O₇₋ₓ single crystal having the three-layered perovskite structure was epitaxially grown on the (110) plane of the substrate.

The SEM photograph of the thin film of the single crystal was taken to confirm the surface smoothness.

### Example 7

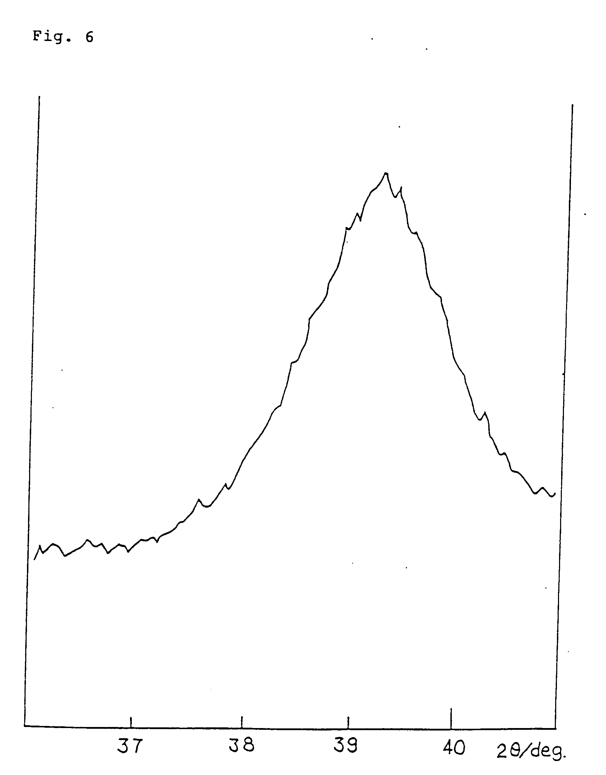

In the same manner as in Example 1 but evaporating metals Y and Sr by electron beam heating and metal Cu by resistance heating and depositing them on the (001) plane of the SrTiO₃ substrate kept at 640°C, a thin film having a thickness of 100 nm (1,000 Å) was formed. An X-ray diffraction pattern of the formed film is shown in Fig. 6, in which the diffraction peak corresponding to the (005) peak of the three layered perovskite structure like YBa₂Cu₃O₇₋ₓ.

### Example 8

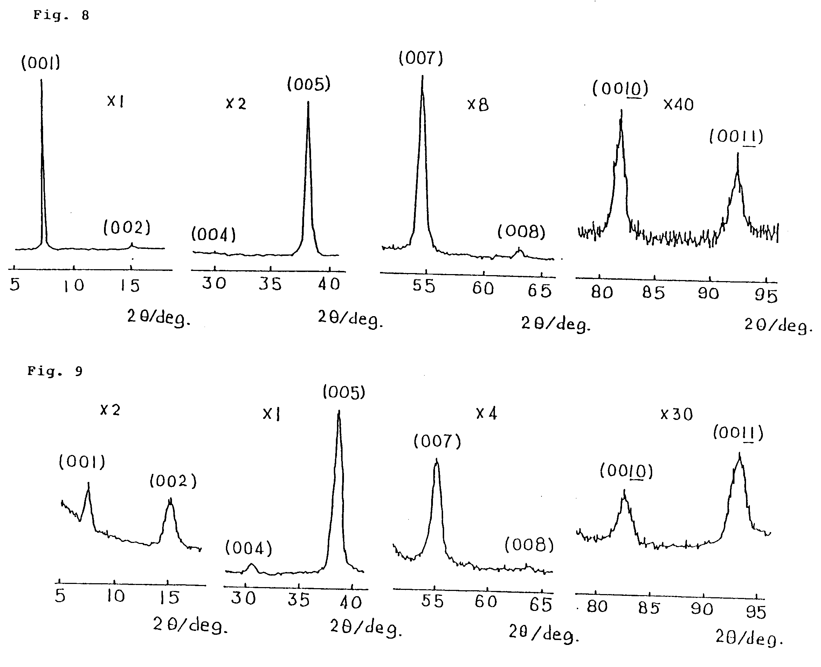

In the same manner as in Example 2 but using Dy or Er in place of Y, a thin film was formed. The X-ray diffraction patterns were shown in Fig. 7 (for Dy) and Fig. 8 (for Er). The formed thin film in which Ln was Dy or Er was characterized in that the intensity of the (001) peak was stronger than that in the case where Ln was Y. This is because the spacing corresponding to the (001) peak is a spacing of the rare metal elements, so that, in case of Dy or Er having the larger atomic number, both the scattering factors for the X-ray are larger than that of Y and therefore the diffraction peak of (001) becomes stronger.

### Example 9

In the same manner as in Example 2 except that an injection nozzle was inserted in a doughnut shaped oxygen diffusion chamber surrounding the periphery of the substrate, and oxygen injected from the nozzle was once diffused in the chamber and then supplied from slits provided on an inner peripheral wall over the substrate surface, a thin film having a thickness of 10 nm (100 Å) was formed.

The X-ray diffraction pattern of the formed thin film is shown in Fig. 9.

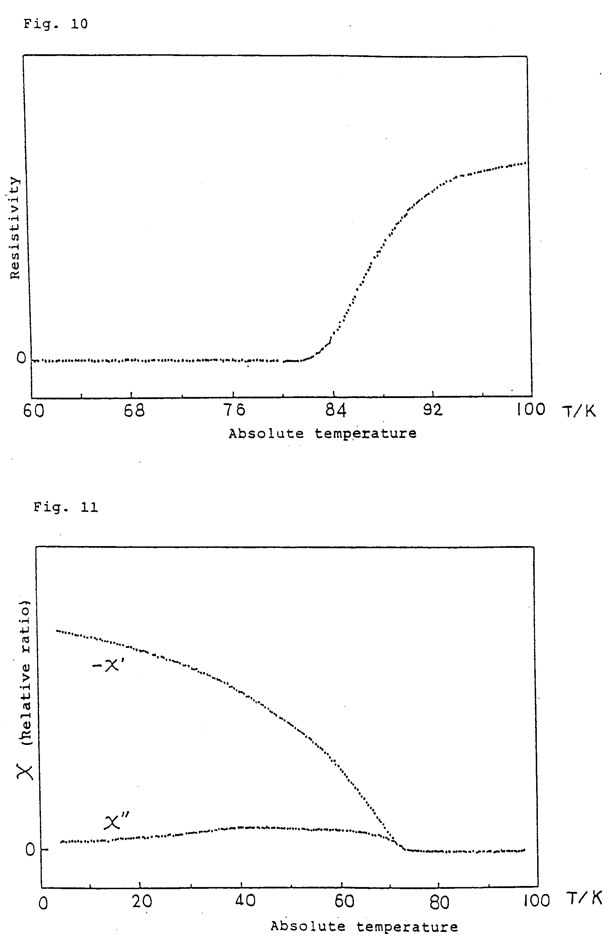

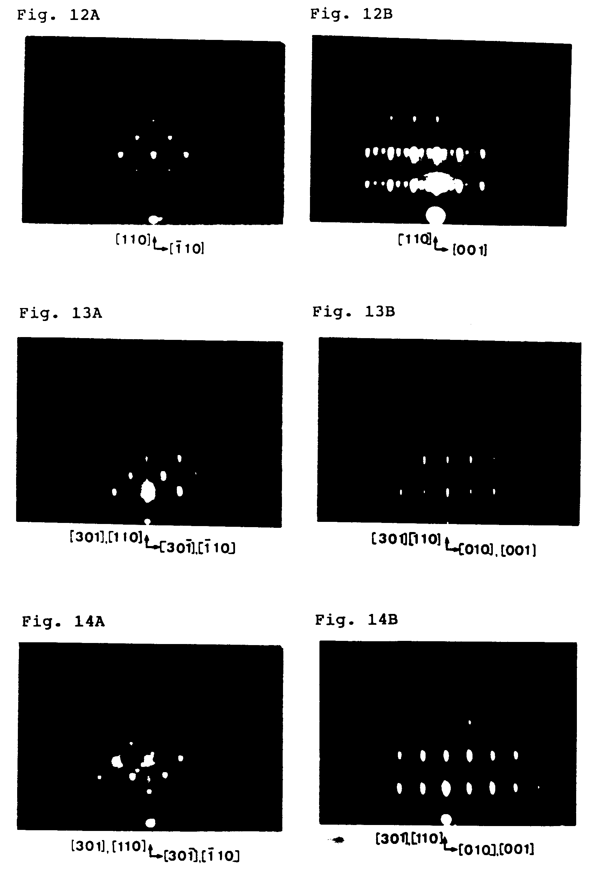

The thin film was then post-heat-treated in the oxygen atmosphere in the same manner as in Example 5. Change of the electrical resistance against temperature of the oxidation-treated thin film is shown in Fig. 10, and change of the complex susceptibility against temperature of the same thin film is shown in Fig. 11.

From these results, it is understood that the thin film of 10 nm (100 Å) in thickness was superconductive below 82 K.

### Example 10

In the same manner as in Example 9 but using, as a substrate, the SrTiO₃ single crystal with a surface of its (110) plane and heating the substrate to 530°C, 550°C, 580°C or 630°C, a thin film having a thickness of 50 nm (500 Å) was formed.

On each of the four thin films, an electron beam was irradiated along a direction of [001] or [110] of the substrate to confirm the crystal orientation of each thin film by RHEED.

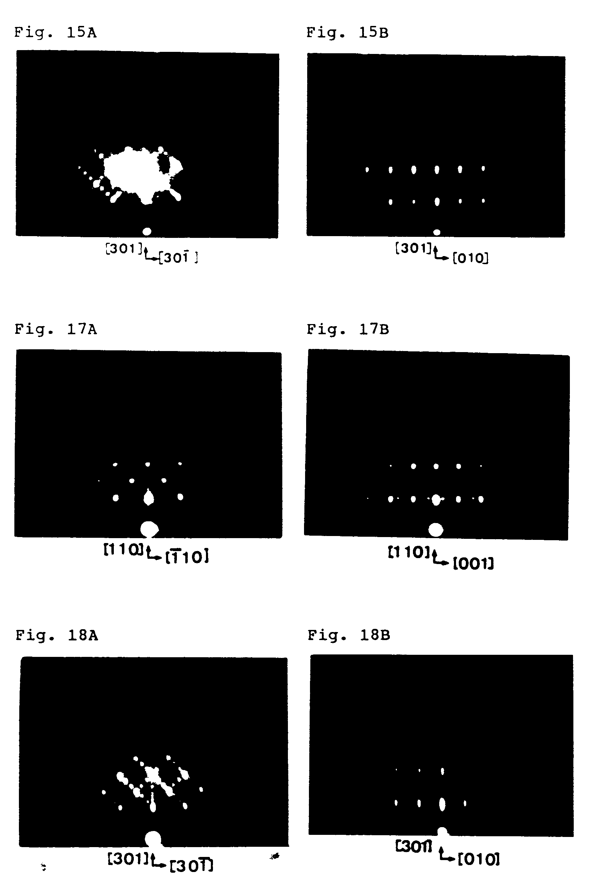

The results are shown in Figs. 12A, 13A, 14A and 15A (along the [001] direction) and Figs. 12B, 13B, 14B and 15B (along the [110] direction). At 530°C, as seen from Figs. 12A and 12B, the thin film of YBa₂Cu₃O₇₋ₓ single crystal having the (110) plane which was parallel with the (110) plane of the substrate SrTiO₃ single crystal was formed. At 630°C, as seen from Figs. 15A and 15B, the thin film of YBa₂Cu₃O₇₋ₓ single crystal having the (103) plane which was parallel with the (110) plane of the substrate SrTiO₃ single crystal was formed.

At 550°C and 580°C which are between 530°C and 630°C, as seen from Figs. 13A, 13B, 14A and 14B, the thin films containing a mixture of (110) and (103) orientations of the YBa₂CU₃O₇₋ₓ were formed.

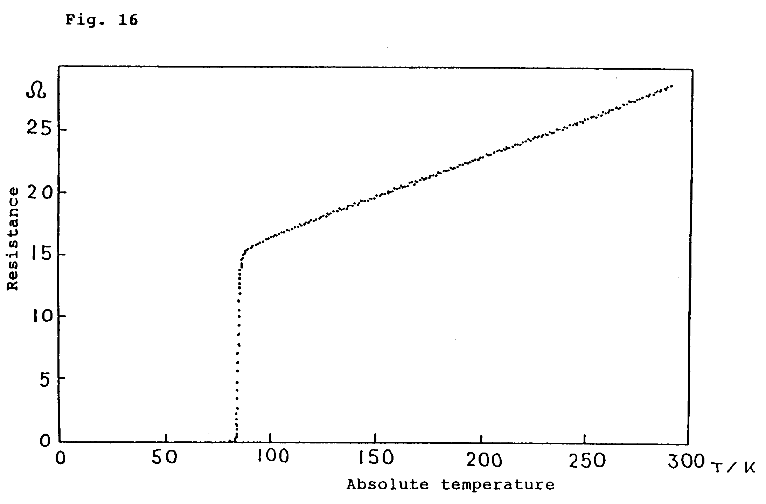

The thin film of YBa₂Cu₃O₇₋ₓ single crystal which was formed at 630°C and had a thickness of 50 nm (500 Å) was heat-treated in the oxygen atmosphere in the same manner as in Example 5 and change of the electrical resistance against temperature was measured. The results are shown in Fig. 16, which confirmed that the oxidation-treated thin film exhibited superconductivity around 80 K.

### Example 11

In the same manner as in Example 10 but using Er in place of Y and heating the substrate to 530°C, 580°C or 630°C, a thin film was formed.

RHEED photographs of these three thin films were taken by irradiating the electron beam along two directions as in Example 10 to confirm the crystal structures.

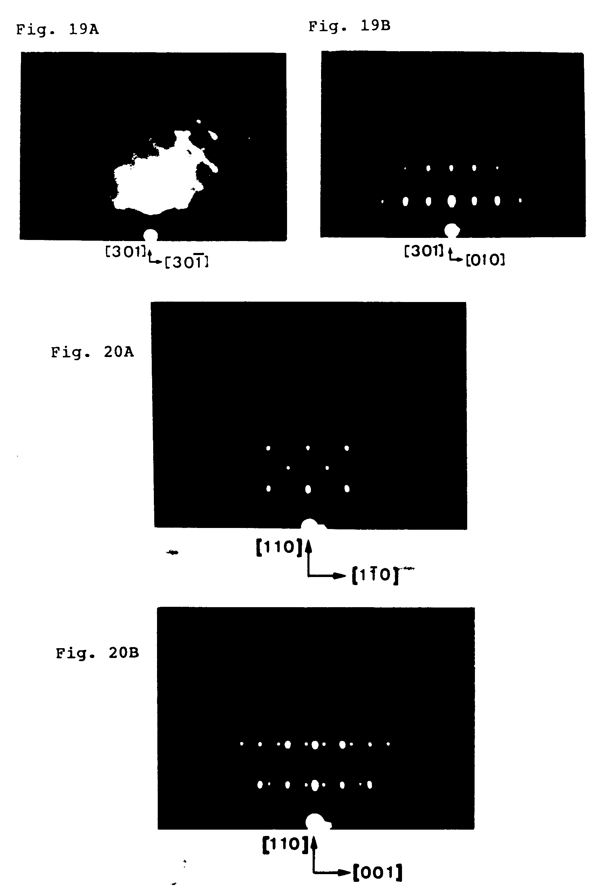

The results are shown in Figs. 17A, 18A and 19A (along the [001] direction) and Figs. 17B, 18B and 19B (along the [110] direction). At 530°C, as seen from Figs. 17A and 17B, the thin film of ErBa₂CU₃O₇₋ₓ single crystal having the (110) plane which was parallel with the (110) plane of the substrate SrTiO₃ single crystal was formed. At 630°C, as seen from Figs. 19A and 19B, the thin film of ErBa₂Cu₃O₇₋ₓ single crystal having the (103) plane which was parallel with the (110) plane of the substrate SrTiO₃ single crystal was formed.

At 580°C, as seen from Figs. 18A and 18B, the thin film containing a mixture of (110) and (103) orientations of the ErBa₂Cu₃O₇₋ₓ single crystals was formed.

### Example 12

In the same manner as in Example 9 but using, as a substrate, the SrTiO₃ single crystal with its (110) plane forming a surface and heating the substrate to 520°C, a thin film having a thickness of 15 nm (150 Å) was formed.

Then, in the same manner as in Example 9 but using the substrate on which the thin film having a thickness of 15 nm (150 Å) as the substrate and heating the substrate to 630°C, a second thin film having a thickness of 85 nm (850 Å) was formed.

RHEED photographs of the second thin film having the thickness of 85 nm (850 Å) was taken by irradiating the electron beam along two directions as in Example 10 to confirm the crystal structures.

The results are shown in Figs. 20A and 20B. As seen from these figures, a thin film of YBa₂Cu₃O₇₋ₓ single crystal having the (110) plane which was parallel with the (110) plane of the substrate SrTiO₃ single crystal was formed.

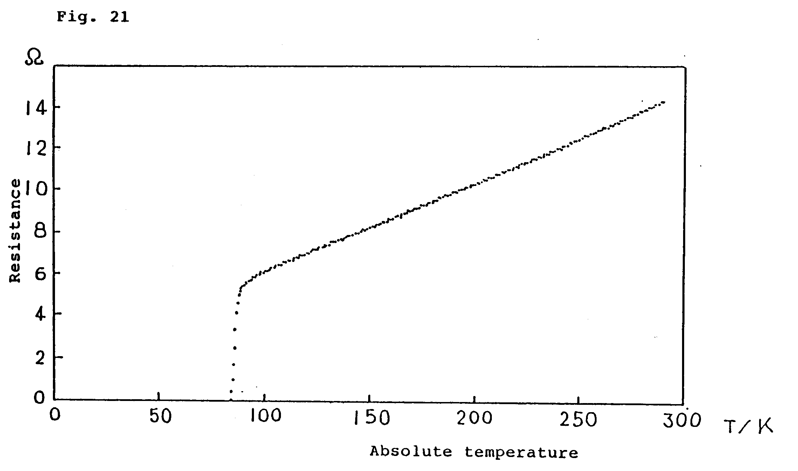

The thin film of YBa₂Cu₃O₇₋ₓ single crystal having the thickness of 85 nm (850 Å) was heat-treated in an oxygen atmosphere in the same manner as in Example 5 and change of the electrical resistance against temperature was measured. The results are shown in Fig. 21, which confirmed that the oxidation-treated thin film exhibited superconductivity around 80 K.

## Claims

1. A process of producing a thin film consisting of a single crystalline oxide superconductor of the formula (I)
LnA₂Cu₃O₇₋ₓ (I)
wherein Ln is at least one of the rare earth elements Y, Nd, Sm, Eu, Gd, Dy, Ho, Er, Tm and Yb and A is at least one of the alkaline earth metals Ba, Sr and Ca which has a three-layered perovskite structure, which comprises simultaneously evaporating Ln, A and Cu in an atomic ratio of about 1:2:3 from discrete evaporation sources of Ln, A and Cu to deposit them on a single crystal substrate in a vacuum vessel while supplying oxygen gas towards the substrate to form an oxygen-rich atmosphere having a pressure of 1.33 to 13.3 Pa at the substrate.

2. The process according to claim 1, which comprises further generating a plasma during the step of simultaneously evaporating Ln, A and Cu in an atomic ratio of about 1:2:3 form discrete evaporation sources of Ln, A and Cu.

3. The process according to any one of claims 1 and 2, wherein the single crystal used as the substrate has its (001) plane forming the substrate surface, and the (001) plane of the formed single crystal is parallel with the film surface.

4. The process according to claim 3, wherein the substrate is heated to a temperature of not lower than 500°C while depositing the film.

5. The process according to any one of claims 1 and 2, wherein the single crystal used as the substrate has its (110) plane forming the substrate surface, and the (110) plane of the formed single crystal is parallel with the film surface.

6. The process according to claim 5, wherein firstly a thin film of the single crystal of the oxide of the formula (I) in which its (110) plane is parallel with the film surface is formed on the substrate heated to a temperature not lower than 500°C and lower than 550°C while depositing the film, and then an oxide of the formula (I) in which its (110) plane is parallel with the film surface is deposited on the firstly formed thin film heated at a temperature of not lower than 550°C.

7. The process according to any one of claims 1 and 2, wherein the single crystal used as the substrate has its (110) plane forming the substrate surface, and the (103) plane of the formed single crystal is parallel with the film surface.

8. The process according to claim 7, wherein the substrate is heated to a temperature of not lower than 550°C while depositing the film.

## Patentansprüche

1. Verfahren zur Herstellung einer dünnen Schicht, bestehend aus einem monokristallinen Oxid-Supraleiter der Formel (I)
LnA₂Cu₃O₇₋ₓ
wobei Ln mindestens eines der Seltenerdelemente Y, Nd, Sm, Eu, Gd, Dy, Ho, Er, Tm und Yb bedeutet und A mindestens eines der Erdalkalimetalle Ba, Sr und Ca bedeutet, mit einer dreischichtigen Perowskit-Struktur, umfassend das gleichzeitige Verdampfen von Ln, A und Cu in einem Atomverhältnis von etwa 1:2:3 aus einzelnen Verdampferquellen für Ln, A und Cu, um sie in einem Vakuumgefäß auf einem Einkristallsubstrat abzuscheiden, wobei Sauerstoffgas gegen das Substrat geleitet wird, um am Substrat eine sauerstoffreiche Atmosphäre mit einem Druck von 1,33 bis 13,3 Pa zu erzeugen.

2. Verfahren nach Anspruch 1, umfassend ferner die Erzeugung eines Plasmas während des Schrittes des gleichzeitigen Verdampfens von Ln, A und Cu in einem Atomverhältnis von etwa 1:2:3 aus einzelnen Verdampferquellen für Ln, A und Cu.

3. Verfahren nach einem der Ansprüche 1 und 2, wobei die (001) Ebene des als Substrat verwendeten Einkristalls die Substratoberfläche bildet und die (001) Ebene des erzeugten Einkristalls zur Schichtoberfläche parallel ist.

4. Verfahren nach Anspruch 3, wobei das Substrat während der Abscheidung der Schicht auf eine Temperatur von nicht unter 500°C erhitzt wird.

5. Verfahren nach einem der Ansprüche 1 und 2, wobei die (110) Ebene des als Substrat verwendeten Einkristalls die Substratoberfläche bildet und die (110) Ebene des erzeugten Einkristalls zur Schichtoberfläche parallel ist.

6. Verfahren nach Anspruch 5, wobei zuerst eine dünne Schicht des Einkristalls des Oxids der Formel (I), dessen (110) Ebene parallel zur Schichtoberfläche ist, auf dem, während der Abscheidung der Schicht auf eine Temperatur von nicht unter 500°C und unter 550°C erhitzten, Substrat erzeugt wird und danach ein Oxid der Formel (I), dessen (110) Ebene parallel zur Schichtoberfläche ist, auf der zuerst erzeugten, auf eine Temperatur nicht unter 550°C erhitzten, dünnen Schicht abgeschieden wird.

7. Verfahren nach einem der Ansprüche 1 und 2, wobei die (110) Ebene des als Substrat verwendeten Einkristalls die Substratoberfläche bildet und die (103) Ebene des erzeugten Einkristalls zur Schichtoberfläche parallel ist.

8. Verfahren nach Anspruch 7, wobei das Substrat während der Abscheidung der Schicht auf eine Temperatur von nicht unter 550°C erhitzt wird.

## Revendications

1. Procédé de fabrication d'un film mince constitué d'un supraconducteur d'oxyde monocristallin de formule (I)
LnA₂Cu₃O₇₋ₓ (I)
dans laquelle Ln est au moins l'un des éléments des terres rares Y, Nd, Sm, Eu, Gd, Dy, Ho, Er, Tm et Yb et A est au moins l'un des métaux alcalino-terreux Ba, Sr et Ca qui possède une structure de pérovskite à trois couches, comportant simultanément l'évaporation de Ln, A et Cu selon un rapport atomique d'environ 1:2:3 à partir de sources d'évaporation discrètes de Ln, A et Cu pour les déposer sur un substrat monocristallin dans une chambre à vide tout en délivrant de l'oxygène gazeux au substrat pour former une atmosphère riche en oxygène présentant une pression de 1,33 à 13,3 Pa sur le substrat.

2. Procédé selon la revendication 1, comportant en outre la génération d'un plasma durant l'étape d'évaporation simultanée de Ln, A et Cu selon un rapport atomique d'environ 1:2:3 à partir de sources d'évaporation discrètes de Ln, A et Cu.

3. Procédé selon l'une quelconque des revendications 1 et 2, dans lequel le monocristal utilisé en tant que substrat a son plan (001) formant la surface du substrat, et le plan (001) du monocristal formé est parallèle à la surface du film.

4. Procédé selon la revendication 3, dans lequel le substrat est chauffé à une température non inférieure à 500°C durant le dépôt du film.

5. Procédé selon l'une quelconque des revendications 1 et 2, dans lequel le monocristal utilisé en tant que substrat a son plan (110) formant la surface du substrat, et le plan (110) du monocristal formé est parallèle à la surface du film.

6. Procédé selon la revendication 5, dans lequel tout d'abord un film mince du monocristal d'oxyde de formule (I) dans lequel son plan (110) est parallèle à la surface du film est formé sur le substrat chauffé à une température non inférieure à 500°C et inférieure à 550°C durant le dépôt du film, ensuite un oxyde de formule (I) dans lequel son plan (110) est parallèle à la surface du film est déposé sur le film mince formé en premier lieu chauffé à une température non inférieure à 550°C.

7. Procédé selon l'une quelconque des revendications 1 et 2, dans lequel le monocristal utilisé en tant que substrat a son plan (110) formant la surface du substrat, et le plan (103) du monocristal formé est parallèle à la surface du film.

8. Procédé selon la revendication 7, dans lequel le substrat est chauffé à une température non inférieure à 550°C durant le dépôt du film.
